# EUROPEAN PATENT APPLICATION

(11) **EP 4 567 798 A1**
(43) Date of publication of application: **11.06.2025**
(21) Application number: 23215119.1
(22) Date of filing: 08.12.2023
(51) Int. Cl.: G11C 5/02, G11C 5/06, G11C 7/18, G11C 8/14, G11C 11/408, G11C 11/4091, G11C 11/4097, G11C 8/12, H10B 12/00

(54) **A 3D DRAM WITH VERTICAL BIT LINES**

(71) Applicant: Imec VZW, 3001 Leuven (BE); Katholieke Universiteit Leuven KU Leuven Research & Development, 3000 Leuven (BE)
(72) Inventor: Wang, Bowen, 3001 Leuven (BE); Oh, Hyungrock, 1200 Brussels (BE); Gupta, Mohit, 3001 Heverlee (BE)
(74) Representative: Roth, Sebastian

(57) **Abstract**

The present disclosure relates to dynamic random access memory (DRAM). In particular, this disclosure proposes a 3D DRAM having vertical bit lines. The DRAM comprises a block with a 3D array of memory cells. The block comprises multiple planes stacked along a first axis. Each plane comprises a 2D array of memory cells organized in rows extending along a second axis perpendicular to the first axis, and columns extending along a third axis perpendicular to the first and the second axis. The block is divided into multiple sub-blocks arranged along the second axis, each sub-block containing one column of memory cells of each plane. The DRAM further comprise a plurality of bit lines, wherein each bit line extends along the first axis in one of the sub-blocks, and is connected to one memory cell in each plane. The DRAM also has a plurality of global bit lines, wherein one or more global bit lines are connected to the bit lines in each sub-block. The DRAM also has a plurality of sense amplifiers, wherein each sense amplifier is connected to one of the global bit lines.

## Description

### TECHNICAL FIELD

The present disclosure relates to dynamic random access memory (DRAM). In particular, this disclosure proposes a 3D DRAM, that is, a DRAM with a 3D array of memory cells. The 3D DRAM of this disclosure comprises vertical bit lines.

### BACKGROUND

Currently, there are difficulties in making DRAM smaller while increasing its storage capacity. In particular, DRAM scaling is facing challenges in terms of reducing the memory cell area, increasing the memory cell density, and achieving higher aspect ratios in the vertical direction of the memory cell. There have been various approaches for creating 3D DRAM to address these difficulties. However, most of these conventional approaches concentrate only on the individual memory bit cells and their organization into a memory cell array, while not considering the connections between the memory cells and the core circuits, like sense amplifiers and word line drivers.

A first challenge arises from a size discrepancy between the smaller bit line pitch (BLP) and the larger bit line sense amplifier (BLSA). For example, for advanced DRAM technology, the BLP is about ~3.4F (44nm), while the area of a BLSA is estimated to be 284F2 (88nm by 6.25µm). For a 2D DRAM, one BLSA can be located between two BLPs, on either side of an array block (MAT). In this setup, multiple BLSAs are arranged similarly to the bit lines in one direction (either x-direction or y-direction). However, for a 3D DRAM, the bit lines are arranged in two directions (in both x-direction and y-direction), which restricts the placement and routing of the BLSAs. This affects the performance and area efficiency of the 3D DRAM.

A second challenge arises from the number of BLSAs. For a 2D DRAM, each bit line is connected to a BLSA, and all the memory cells on a word line operate simultaneously by word line activation. In other words, there should be an equal number of BLSAs and bit lines in the MAT, which leads to an increased area consumption. Transferring this kind of configuration (i.e., one bit line to one BLSA) to a 3D DRAM is problematic, because it brings about issues with the placement and connection to the BLSA, and also leads to a larger area consumption.

### SUMMARY

Therefore, an objective of this disclosure is to provide an improved 3D DRAM. In particular, an objective is to reduce the area consumption in view of the above-described issues. Another objective is to reduce the parasitic bit line loading in the 3D DRAM. Another objective is to reduce the number of word line drivers in the 3D DRAM. To this end, the disclosure has the objective to provide both a 3D DRAM memory cell array architecture, and a way to connect the 3D DRAM memory cell array to the sense amplifiers and word line drivers, respectively. Thereby, the disclosure aims for a one transistor and one capacitor (1T1C) memory cell configuration.

These and other objectives are achieved by the solutions of this disclosure as described in the independent claims. Advantageous implementations of these solutions are described in the dependent claims.

A first aspect provides a DRAM comprising: a block comprising a 3D array of memory cells; wherein the block comprises multiple planes stacked along a first axis, each plane comprising a 2D array of memory cells organized in rows extending along a second axis perpendicular to the first axis and columns extending along a third axis perpendicular to the first and the second axis; and wherein the block is divided into multiple sub-blocks arranged along the second axis, each sub-block containing one column of memory cells of each plane; the DRAM further comprising: a plurality of bit lines, wherein each bit line extends along the first axis in one of the sub-blocks and is connected to one memory cell in each plane; a plurality of global bit lines, wherein one or more of the global bit lines are connected to the bit lines in each sub-block; and a plurality of sense amplifiers, wherein each sense amplifier is connected to one of the global bit lines.

The DRAM with its 3D array of memory cells is a 3D DRAM. The 3D DRAM may block-addressable, and may even sub-block-addressable. This can be beneficial for its performance, endurance, and energy efficiency, and also the storage density may be increased.

The DRAM of the first aspect comprises so-called vertical bit lines, as they extend along the first axis, which is considered the vertical axis in this disclosure. The connection of the vertical bit lines to the global bit lines reduces the area consumption, due to a more relaxed placement and routing of the sense amplifiers. Additionally, a parasitic bit line loading can be reduced in the 3D DRAM of the first aspect.

In an implementation, each global bit line extends along the third axis, and is associated with one respective sub block, and is connected to all the bit lines in the respective sub-block.

In an implementation, each global bit line extends along the third axis, and each sub-block is associated with a respective group of global bit lines, and each global bit line of the respective group is connected to a respective group of bit lines in the sub-block.

In an implementation, each group of bit lines comprises bit lines that are arranged sequentially along the third axis.

In an implementation, each group of bit lines comprises bit lines that are arranged interleaved along the third axis.

In an implementation, the DRAM further comprises a plurality of word lines, wherein each word line extends in one of the planes along the second axis, and is connected to one memory cell in each sub-block.

In an implementation, each global bit line extends along the second axis, and is connected to one bit line in each sub-block of the block.

In an implementation, each global bit extends along the second axis, wherein each global bit line is connected to one bit line in each sub-block of a group of sub-blocks associated with the global bit line, and wherein different global bit lines are associated with different groups of sub-blocks.

In an implementation, each group of sub-blocks comprises sub-blocks that are arranged sequentially along the second axis.

In an implementation, each group of sub-blocks comprises sub-blocks that are arranged interleaved along the second axis.

In an implementation, the DRAM further comprises a plurality of word lines, wherein each word line extends in one of the planes along the third axis, and is connected to one column of memory cells in that plane.

In an implementation, the DRAM further comprises a single word line driver shared among all the word lines; or multiple word line drivers, wherein each word line driver is shared among all the word lines of the same plane.

In this way, the number of word line drivers may be reduced. This may lead to a reduction of the area consumed by word line drivers as well.

In an implementation, the DRAM further comprises one or more word line selectors configured to selectively connect the one or more word line drivers to the word lines; wherein each word line selector comprises a plurality of global word lines, and each global word line is connected to a group of word lines.

In an implementation, each group of word lines comprises word lines that are arranged sequentially along the third axis if each group of bit lines comprises bit lines that are arranged interleaved along the third axis; or each group of word lines comprises word lines that are arranged interleaved along the third axis if each group of bit lines comprises bit lines that are arranged sequentially along the third axis.

In an implementation, each group of word lines comprises word lines that are arranged sequentially along the second axis if each group of bit lines comprises bit lines that are arranged interleaved along the second axis; or each group of word lines comprises word lines that are arranged interleaved along the second axis if each group of bit lines comprises bit lines that are arranged sequentially along the second axis.

In an implementation, the DRAM further comprises: a single word line selector shared among all the word lines; or multiple word line selectors, wherein each word line selector is shared among all the word lines of the same plane; wherein the one or more word line selectors are configured to selectively connect an output of an address decoder to a plurality of word line drivers; and wherein the plurality of word line drivers are connected to the plurality of word lines.

In this way, the number of word line selectors may be reduced. This may lead to a reduction of the area consumed by word line selectors as well. In this implementation, the one or more word line selectors are arranged and connected between the address decoder and the word line drivers. The address decoder may function as a first decoder, and the one or more word line selectors may function as a second decoder. The address decoder may be an address decoder used in a conventional DRAM. The address decoder maybe a circuit that interprets memory addresses received, for example, form a central processing unit (CPU) to select where data is to be read or written in the memory array. The word line drivers could be inverters, for instance.

In summary of the above, this disclosure focuses on a vertical bit line based 3D DRAM architecture, i.e., bit lines extending along the first axis. The disclosure is concerned with the core architecture of the memory cell array, but also considers a connection between the bit lines and the sense amplifiers, as well as a connection between the word lines and the word line driver(s). The proposed configuration allows reducing the number of sense amplifiers and the number of word line drivers, and thus leads to a reduction of area consumed. Moreover, parasitic loadings, particularly on the bit lines, can be minimized. Additionally, the number of planes of the 3D DRAM may be increased with minimized impact on the parasitic loadings and the area consumption.

### BRIEF DESCRIPTION OF THE DRAWINGS

The above described aspects and implementations are explained in the following description of embodiments with respect to the enclosed drawings:
- FIG. 1: shows a perspective view and a top view of a DRAM according to this disclosure with vertical bit lines.
- FIG. 2: shows a perspective view of a first example of a DRAM according to this disclosure.
- FIG. 3: shows a perspective view of a second example of a DRAM according to this disclosure.
- FIG. 4: shows a top view of the DRAM of the first example or the second example.
- FIG. 5: shows a perspective view of a third example of a DRAM according to this disclosure.
- FIG. 6: shows a top view of the DRAM of the third example.
- FIG. 7: shows a perspective view of a fourth example of a DRAM according to this disclosure.
- FIG. 8: shows a top view of the DRAM of the fourth example.
- FIG. 9: shows a perspective view of a fifth example of a DRAM according to this disclosure.
- FIG. 10: shows a perspective view of a sixth example of a DRAM according to this disclosure.
- FIG. 11: shows a top view of the DRAM of the fifth example, the sixth example, or the seventh example.
- FIG. 12: shows a perspective view of an eighth example of a DRAM according to this disclosure.
- FIG. 13: shows a top view of the DRAM of the eighth example.
- FIG. 14: shows a perspective view of a ninth example of a DRAM according to this disclosure.
- FIG. 15: shows a top view of the DRAM of the ninth example.

### DETAILED DESCRIPTION OF EMBODIMENTS

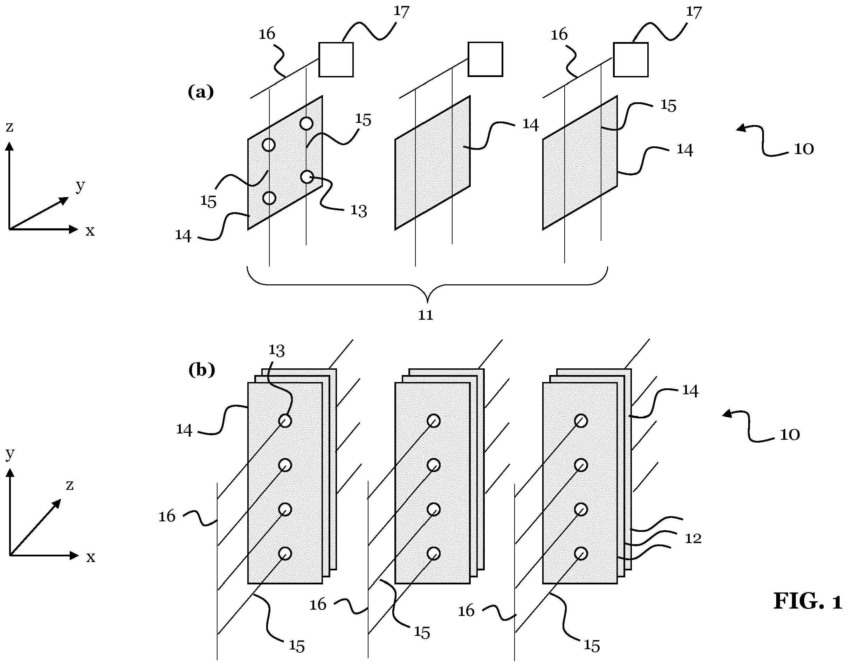

FIG. 1 shows a DRAM 10 according to this disclosure. In particular, FIG. 1(a) shows a perspective view of the DRAM 10, while FIG. 1(b) shows a tow-view of the DRAM 10. The DRAM 10 is a 3D DRAM, as it comprises a block 11 including a 3D array of memory cells 13. The DRAM 10 may comprise more than one such block 11, i.e., may be arranged of multiple blocks 11, which may be individually addressable. The memory cells 13 may each comprise a storage capacitor to store data in the form of charge, and a transistor connected to the storage capacitor and configured to enable writing of data to the storage capacitor or reading data from the storage capacitor. Each memory cell 13 may be able to store one bit of data (information). The memory cells 13 in the 3D DRAM 10 may be arranged in rows, columns, and stacks.

In particular, as shown in FIG. 1(b), the block 11 comprises multiple planes 12, which are stacked along a first axis (the vertical axis in this disclosure, which is the z-axis according to the coordinate system shown in the figures). Each plane 12 comprises a 2D array of memory cells 13, which are organized in rows extending along a second axis perpendicular to the first axis (the second axis is the x-axis in the coordinate system) and columns extending along a third axis perpendicular to the first and the second axis (the third axis is the y-axis in the coordinate system). The stacked planes 13 accordingly include columns, rows, and stacks of memory cells 13, wherein stacks of memory cells 13 comprise memory cells 13 arranged along the first axis.

As further schematically shown in FIG. 1(a) and 1(b), the block 11 is divided into multiple sub-blocks 14, which are arranged along the second axis. Each sub-block 14 contains one column of memory cells 13 of each plane 12. The consecutive arrangement of the sub-blocks 14 defines the rows of memory cells 13 along the second axis. Each sub-block 14 may be individually addressable in the DRAM 10.

The DRAM 10 also comprises a plurality of bit lines 15. Each bit line 15 extends along the first axis in one of the sub-blocks 14. The bit lines 15 are thus referred to as vertical bit lines in this disclosure. Each bit line 15 is connected to one memory cell 13 in each plane 12. That is, each bit line 15 is connected to a stack of memory cells 13.

Moreover, the DRAM 10 includes a plurality of global bit lines 16. One or more of the global bit lines 16 are connected to the bit lines 15 in each sub-block 14. Just as an example, the illustration in FIG. 1 shows one global bit line 16 per sub-block 14, wherein the global bit line 16 is connected to all the shown bit lines 15 of said sub-block 14. However, it is also possible that two or more global bit lines 16 are used to connect to the bit lines 15 of a respective sub-block 14.

As shown in FIG. 1(a), the DRAM 10 further comprise a plurality of sense amplifiers 17. Each sense amplifier 17 is connected to one of the global bit lines 16, and is configured to sense (detect) a charge on that global bit line 16. Indirectly, each sense amplifier 17 may thus be connected to - via said global bit line 16 - to multiple bit lines 15, and may thus be able to detect charge coming from at least one bit line 15 onto the global bit line 16. It may be possible in the DRAM 10 to read charge of a single memory cell 13 per sub-block 14 using the bit line 15, global bit line 16 and sense amplifier 17.

In the following, more specific examples of the DRAM 10 according to this disclosure are presented. These examples are all based on the DRAM 10 shown in FIG. 1. Same elements in FIG. 1 and any one of the previous figures share the same reference signs, and may be implemented and/or function likewise. Redundant description is avoided.

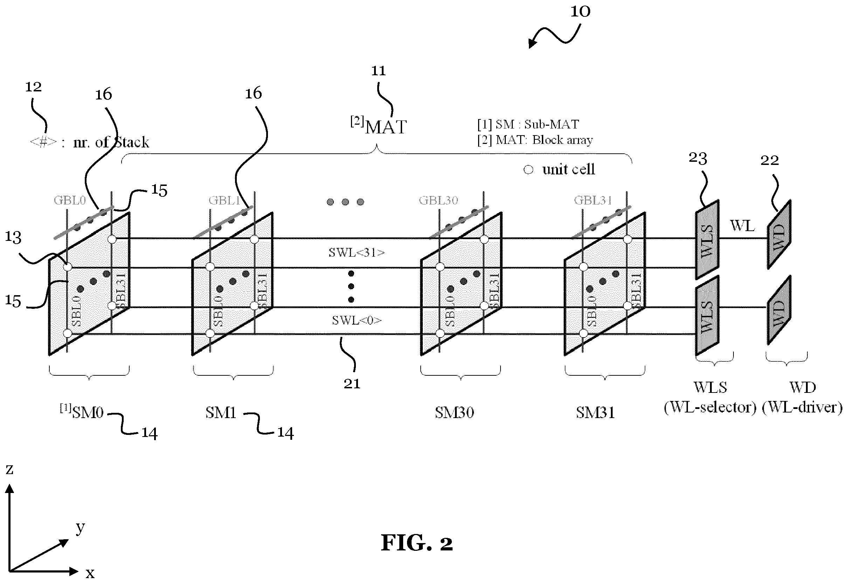

FIG. 2 shows a perspective view of a first example of a DRAM 10 according to this disclosure. In the DRAM 10 of FIG. 2, the block 11 is called a "MAT", and the multiple sub-blocks 14 are respectively called "Sub-MAT" or short "SM". The sub-blocks 14 are numbered SM0 to SM31. Accordingly, each block 11 is composed of 32 sub-blocks 14 in this example. Moreover, each sub-block 14 comprises 32 vertical bit lines 15, which are called and numbered SBL0 to SBL31 per sub block 14.

In order to improve the connection between the bit lines 15 and the sense amplifiers 17 (e.g., BLSAs) in this example - while taking into account the smaller BLP - all the bit lines 15 in each sub-block 14 are connected to a single global bit line 16. Each global bit line 16 extends along the third axis in this example, and is associated with one respective sub block 14 of the multiple sub-blocks 14. Each global bit line 16 is connected to all the bit lines 15 in said respective sub-block 14. The global bit lines 16 are called and numbered GBL0 to GBL 31, and correspond to the SM0 to SM31 in this example. Each global bit line 16 is connected to one sense amplifier 17 (which are not shown in FIG. 2, but they can be seen in FIG. 1).

FIG. 2 shows further that the DRAM 10 comprises a plurality of word lines 21. Each word line 21 extends in one of the stacked planes 12 along the second axis. Thereby, each word line 21 is connected to one memory cell 13 in each of the multiple sub-blocks 14. If the word line 21 operated (charge), the memory cells 13 connected to the word line 21 may be activated. For instance, the transistor connected to the storage capacitor of the memory cell 13 may be turned on, in order to allow charge to be written to or read from the storage capacitor. Reading and writing may be conducted via the bit line 15 connected to this memory cell 13. In total, in this example, there are 32 word lines 21 for each of 32 planes. The word lines 21 are called and numbered SWL<0> to SWL <31>, wherein <#> denotes the particular plane with number # of the 32 planes.

FIG. 2 also shows that the 3D DRAM 10 has, in addition to the 3D memory cell array, a plurality of word line drivers 22 (only two "WD" are shown), and a plurality of word line selectors (only two "WLS" are shown). The word line drivers 22 are located at the right (or left) side of the array, i.e., they offset along the second axis from the memory cell array formed by the sub-blocks 14. For this reason, each word line 21 is common to all the sub-blocks 14, as explained above. Each word line driver 22 is shared among all the word lines 21 of the same plane 12. Thus, there may be 32 word line drivers 22 in this example. However, multiple planes 12 may also share a word line driver 22, which may reduce the number of word line drivers 22 further. The word line selectors 23 are configured to selectively connect the word line drivers 22 to the word lines 21. The word lines selectors 23 allow selecting one word line 21 out of all the word lines 21 in a plane 12. Since only one word line 21 is activated in the block 11 at a time, a word line driver 22 can be shared among multiple word lines 21.

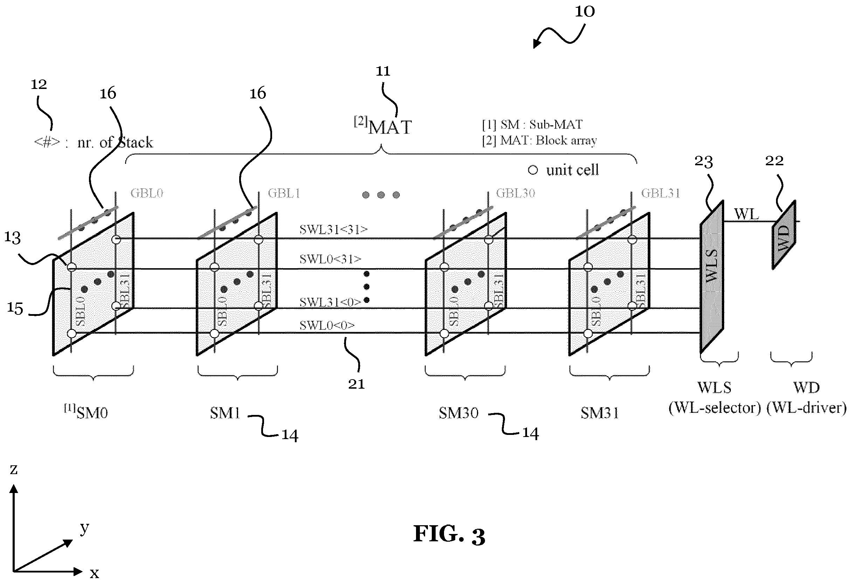

FIG. 3 shows a perspective view of a second example of a DRAM 10 according to this disclosure. The DRAM 10 of FIG. 3 is very similar to that of FIG. 2. In contrast to FIG. 2, the DRAM 10 of FIG. 3 comprises a single word line driver 22 shared among all the word lines 21. Moreover, it comprises a single word line selector 23 configured to selectively connect the word line driver 22 to the word lines 21. That is, while in FIG. 2 the word line driver 22 is common by the plane 12 or stack level, in FIG. 3 the word line driver 22 is common by the block level. In FIG. 3, the word lines 21 are called and numbered SWL0<0> to SWL31<0> to SWL0<31> to SWL31<31>, wherein <#> denotes the particular plane with number # of the 32 planes, each plane having 31 word lines 21.

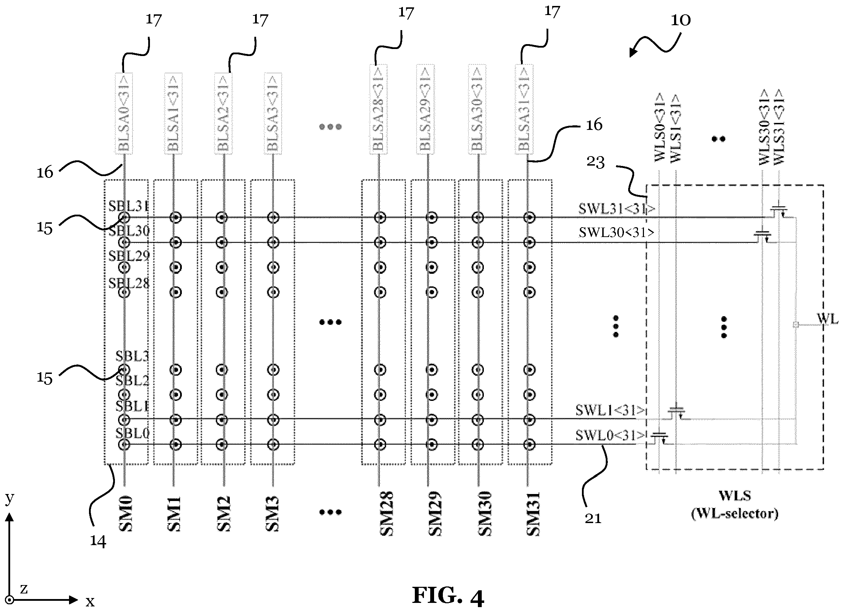

FIG. 4 shows a top view of the DRAM 10 of the first example or the second example. In particular, FIG. 4 shows only one plane 12 of the plurality of planes 12 of the DRAM 10. FIG. 4 shows how the bit lines 15 are connected, on the one hand, to the memory cells 13 of the 2D array of that plane 12 and, on the other hand, to the global bit lines 16. FIG. 4 also shows how the word lines 21 are connected, on the one hand, to the memory cells 13 of the 2D array of that plane 12 and, on the other hand, to the word line selector 23.

The word line selector 23 shown in FIG. 4 is connected to all the word lines 21 of the plane 12 that is shown. In particular, the word line selector 23 is shown to be connected to all word lines SWL0<31> to SWL31<31> of the plane <31> that is shown.

The word line driver(s) 22 in FIG. 3 and FIG. 4 may be connected to an address decoder of the DRAM 10, i.e., they may be arranged and connected between the one or more word line selectors 23 and the address decoder. This configuration could also be swapped, i.e., one or more word line selectors 23 could be arranged and connected between the address decoder and a plurality of word line drivers 22, wherein the word line drivers 22 are connected to the word lines 21.

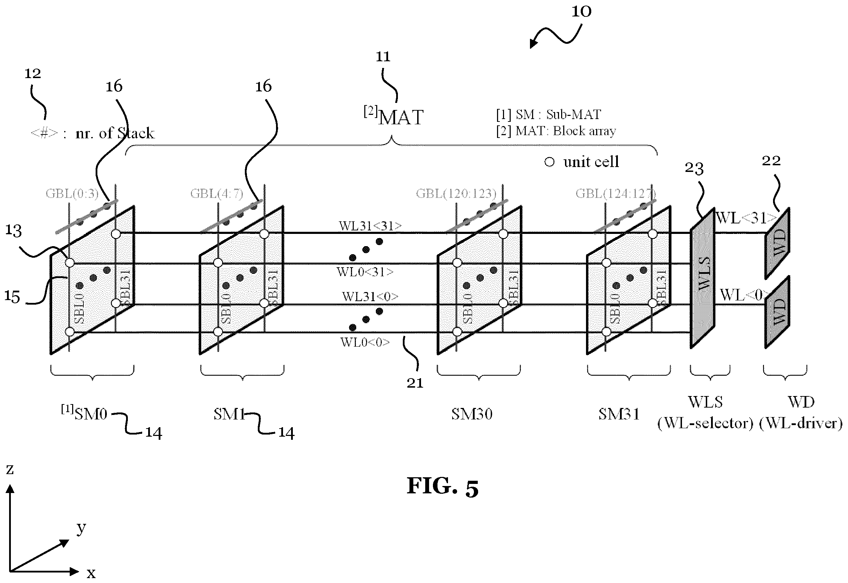

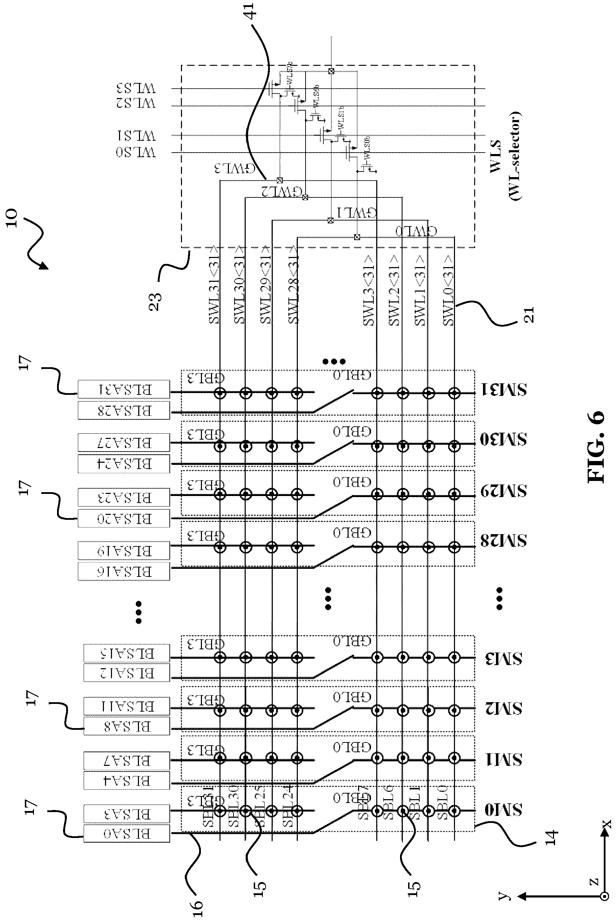

FIG. 5 shows a perspective view of a third example of a DRAM 10 according to this disclosure. FIG. 6 shows a top view of the DRAM 10 of the third example. In this third example, each global bit line 16 extends along the third axis, like in FIG. 2 and FIG. 3. However, each sub-block 14 is associated with a respective group of global bit lines 16 (e.g., GBL(0:3), GBL(4:7) etc.). Each global bit line 16 of the respective group is connected to a respective group of bit lines 15 in the sub-block 14, which can be seen in FIG. 6.

In the third example, each group of bit lines 15 comprises bit lines 15 that are arranged sequentially along the third axis. For example, as shown in FIG. 6, in the SM0, the GBL0 is connected to SBL0, SBL1, SBL6 and SBL7, which are consecutively arranged along the third axis. The GBL3 is connected to SBL24, SBL25, SBL30, SBL31, which are also consecutively arranged along the third axis.

As can also be seen in FIG. 6, each global word line 41 of each word line selector 23 is connected to a group of word lines 21. Each group of word lines 21 comprises word lines 21 that are arranged interleaved along the third axis in this case. For example, GWL0 is connected to SWL0<31> and SWL28<31>, while GWL1 is connected to SWL1<31> and SWL29<31>, GWL2 is connected to SWL2<31> and SWL30<31>, and GWL3 is connected to SWL3<31> and SWL31<31> of the shown plane <31>.

FIG. 5 and 6 accordingly show a 3D DRAM memory architecture, wherein the global bit line 16 of FIG. 3 is divided into multiple (here particularly four) global bit lines 16 per sub-block 14. This may increase the number of data queues and may reduce the parasitic loadings on the global bit lines 16. The connection between the bit lines 15 and the global bit lines 16 is sequential in this case. In the sequential connection case, successive bit lines 15 are connected to the same global bit line 16.

The same arrangements - i.e., sequential or interleaved - can be followed for the connection between the word lines 21 and word line selectors 23. This third example comprises a sequential bit line and an interleaved word line arrangement.

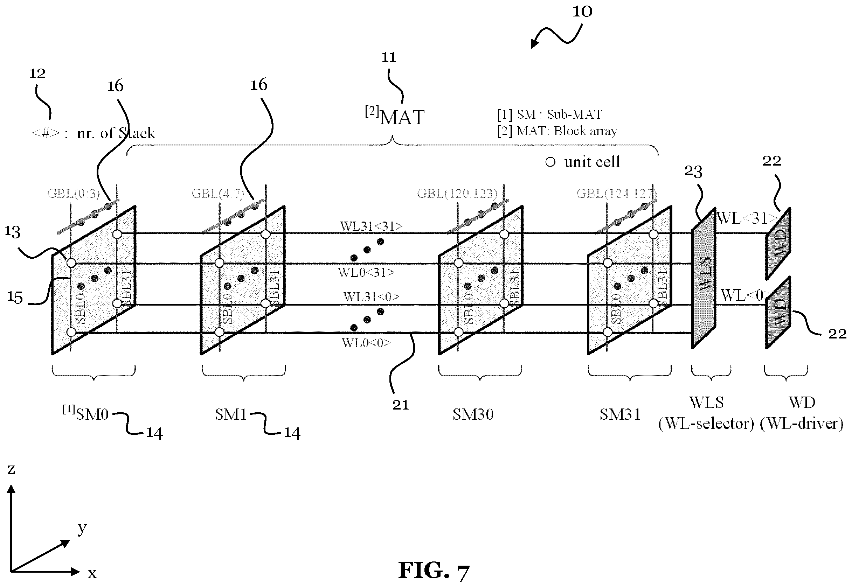

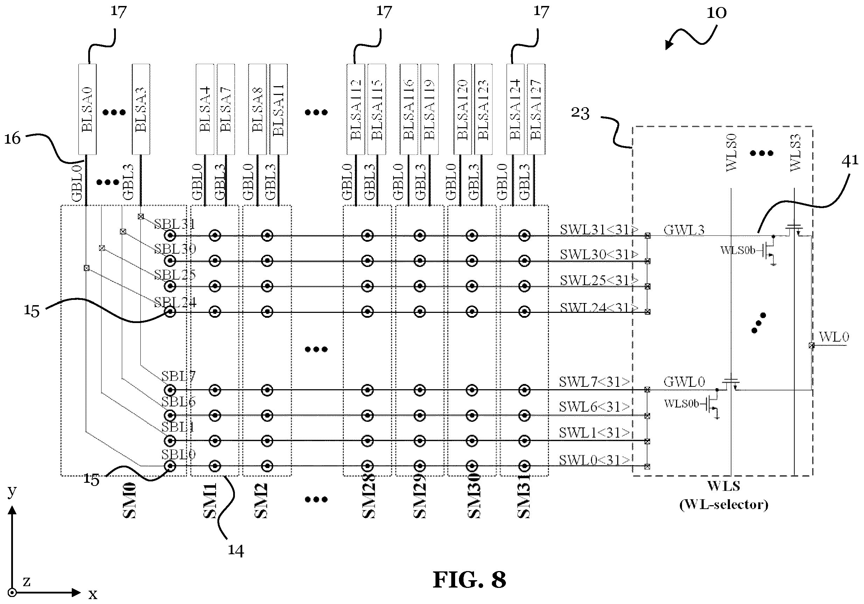

FIG. 7 shows a perspective view of a fourth example of a DRAM 10 according to this disclosure. FIG. 8 shows a top view of the DRAM 10 of the fourth example. In this fourth example, each global bit line 16 extends along the third axis, like in FIG. 2 and FIG. 3. However, each sub-block 14 is associated with a respective group of global bit lines 16, like in FIG. 5. Each global bit line 16 of the respective group is connected to a respective group of bit lines 15 in the sub-block 14, which can be seen in FIG. 8.

In the fourth example, each group of bit lines 15 comprises bit lines 15 that are arranged interleaved along the third axis. For example, as shown in FIG. 8, in SM0, the GBL0 is connected to SBL0 and SBL24, while GBL1 is connected to SBL1 and SBL25, GBL2 is connected to SBL6 and SBL30, and GBL3 is connected to SBL7 and SBL31. Accordingly, the respective bit lines 15 are not consecutively arranged along the third axis, but an interleaved connection is established.

As can also be seen in FIG. 8, each global word line 41 of each word line selector 23 is connected to a group of word lines 21. Each group of word lines 21 comprises word lines 21 that are arranged sequentially along the third axis in this case. For example, GWL0 is connected to SWL0<31>, SWL1<31>, SWL6<31>, and SWL7<31>, while GWL3 is connected to SWL24<31>, SWL25<31>, SWL30<31> and SWL31<31> of the shown plane <31>.

That is, in this fourth example, there is an interleaving connection between bit lines 15 and the global bit lines 16. That is, a mixing of the bit lines 15 is possible for the same global bit line 16. Further, the word lines 21 are connected interleaved to the global word lines 41. This example thus comprises an interleaved bit line and a sequential word line arrangement.

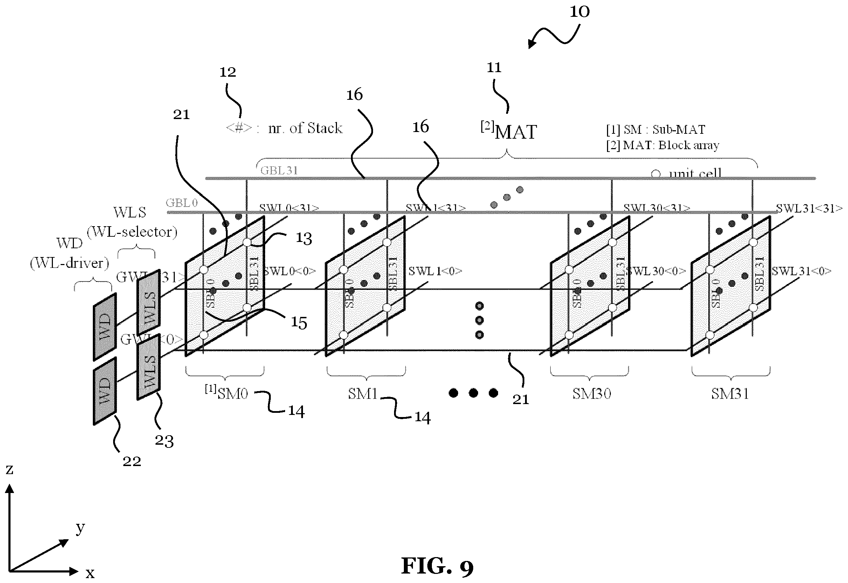

FIG. 9 shows a perspective view of a fifth example of a DRAM 10 according to this disclosure. In the fifth example, multiples global bit lines 16 are connected to the bit lines 15 in each sub-block 14. Each global bit line 16 extends along the second axis, and is connected to one bit line 15 in each sub-block 14 of the block 11.

As is also visible in FIG. 9, the DRAM 10 comprises a plurality of word lines 21, wherein in the fifth example each word line 21 extends in one of the planes 12 along the third axis, and is connected to one column of memory cells 13 in that plane 12. Each sub-block 14 accordingly comprises a plurality of word lines 21, one in each plane 12. Thus, each sub-block 14 may comprise 32 word lines 21 as shown. Further, the DRAM 10 of FIG. 9 comprises multiple word line drivers 22, wherein each word line driver 22 is shared among all the word lines 21 of the same plane 12. The DRAM 10 also comprises multiple word line selectors 23, which are configured to selectively connect the word line drivers 22 to the word lines 21.

In FIG. 9 the word line drivers 22 are located in front of or behind the memory cell array, i.e., are offset along the third axis from the sub-blocks 14. Moreover, each global bit line 16 is thus parallel to the number of the sub-blocks 14 extending along the second axis.

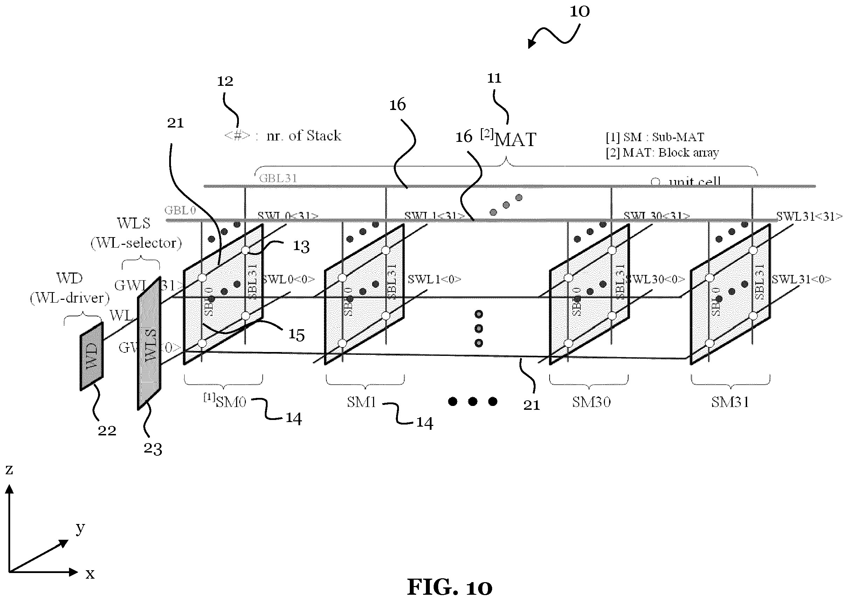

FIG. 10 shows a perspective view of a sixth example of a DRAM 10 according to this disclosure. The DRAM 10 of the sixth example is very similar to the DRAM 10 of the fifth example, however, the DRAM 10 of FIG. 10 comprises only a single word line driver 22 and a single word line selector 23, similarly as shown in FIG. 3. The word line driver placement may thus be per block 11 of the DRAM 10.

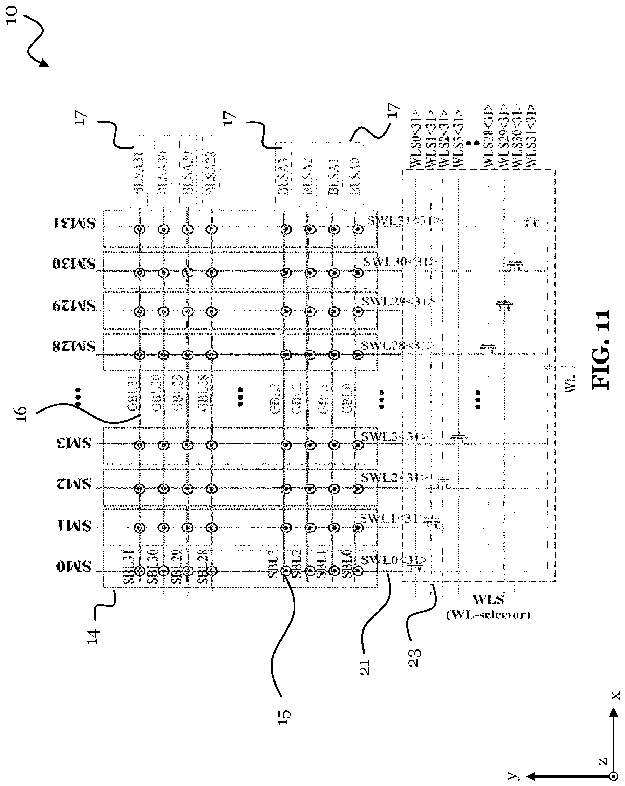

FIG. 11 shows a top view of the DRAM 10 of the fifth, the sixth, or the seventh example. As can be seen, each global bit line 16 extends along the second axis, and is connected to one bit line 15 in each sub-block 14 of the block 11. Further, each global bit line 16 is connected to one sense amplifier 17 (BLSA0<31> to BLSA0 to BLSA31.

The word line selector 23 is connected to all the word lines 21 of the plane 12 that is shown. In particular, the word line selector 23 is connected to the SWL0<31> to SWL31<31> in the plane <31> that is shown, wherein one of these SWLs is in each of the 31 sub-blocks 14.

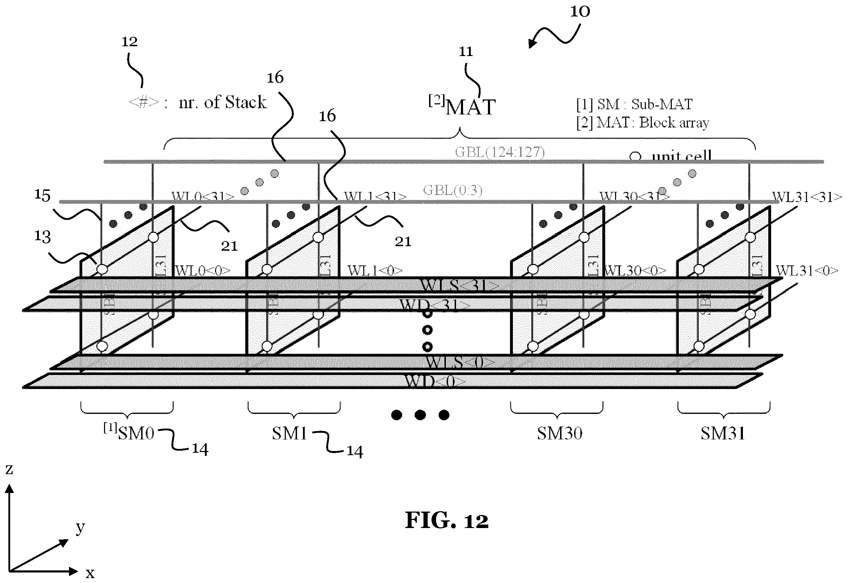

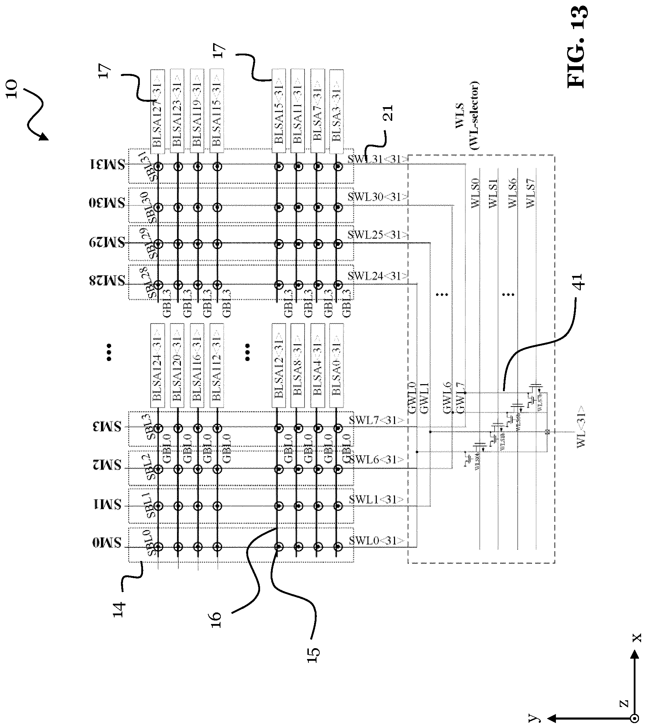

FIG. 12 shows a perspective view of an eighth example of a DRAM 10 according to this disclosure. FIG. 13 shows a top view of the DRAM 10 of the eighth example. In the eight example, each global bit line 16 extends along the second axis. Further, each global bit line 16 is connected to one bit line 15 in each sub-block 14 of a group of sub-blocks 14, wherein the sub-block 14 is associated with the global bit line 16. This stands in contrast to the fifth, sixth, or seventh example, wherein each global bit line 16 is connected to one bit line 15 in each sub-block 14 within the entire block 11. Different global bit lines 16 in the eight example are associated with different groups of sub-blocks 14.

As can be seen in FIG. 13, each group of sub-blocks 14 comprises sub-blocks 14 that are arranged sequentially along the second axis. For instance, the GBL0 is connected to the sub-blocks SM0 to SM3, while the GBL3 is connected to the SM28 to SM31. Further, each global bit line 16 is connected to a group of bit lines 15, which comprises bit lines 15 that are arranged sequentially along the second axis. For instance, GBL0 is connected to SBL0 to SBL3, while GBL3 is connected to SBL28 to SBL31.

Moreover, each word line selector 23 in the eighth example comprises a plurality of global word lines 41, wherein each global word line 41 is connected to a group of word lines 21. For instance, in FIG. 13 GWL0 is connected to the SWL0 and SWL24, while GWL1 is connected to SWL1 and SWL25, GWL6 is connected to SWL6 and SWL30, and GWL7 is connected to SWL7 and the SWL31. That is, each group of word lines 21 comprises word lines 21 that are arranged interleaved along the second axis.

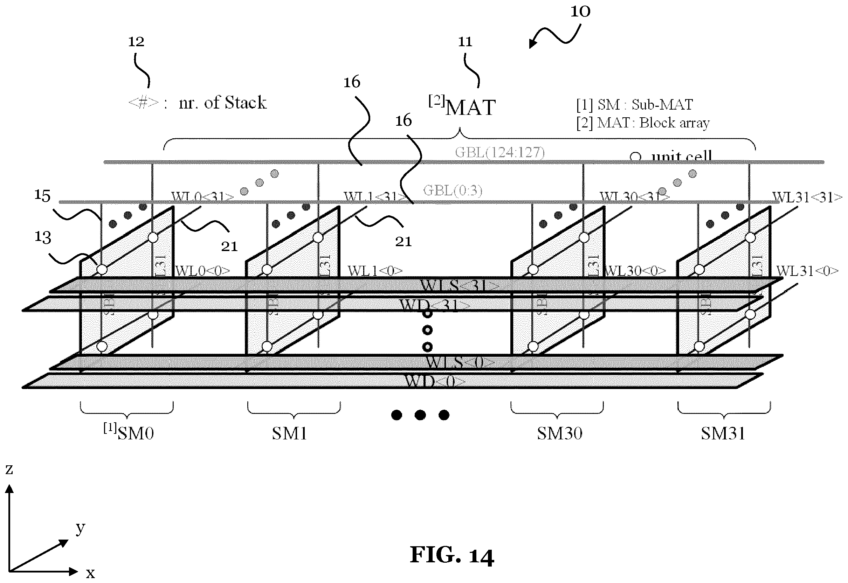

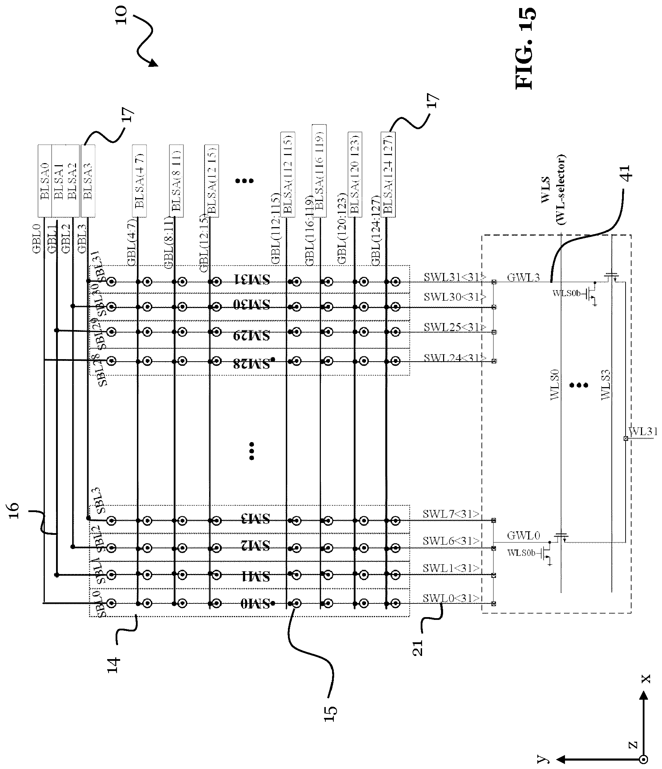

FIG. 14 shows a perspective view of a ninth example of a DRAM 10 according to this disclosure. FIG. 15 shows a top view of the DRAM 10 of the ninth example. The ninth example is very similar to the eight example. However, as can be seen in FIG. 15, each group of sub-blocks 14 comprises sub-blocks 14 that are arranged interleaved along the second axis. For example, GBL0 is associated with SM0 and SM28, while GBL1 is associated with SM1 and SM29, and so forth. Further, each global bit line 16 is connected to a group of bit lines 15, which comprises bit lines 15 that are arranged interleaved along the second axis For instance, GBL0 is connected to the SBL0 and SBL28, while GBL1 is connected to SBL1 and SBL29, and so forth.

Moreover, each word line selector 23 in the eighth example comprises a plurality of global word lines 41, wherein each global word line 41 is connected to a group of word lines 21. For instance, in FIG. 15 GWL0 is connected to SWL0, SWL1, SWL6 and SWL7, while GWL3 is connected to SWL24, SWL25, SWL30 and SWL31. That is, each group of word lines 21 comprises word lines 21 that are arranged sequentially along the second axis.

In summary, this disclosure addresses the challenges that DRAM scaling is facing in terms of memory bit cell area, memory density, and aspect ratio in the vertical direction. The disclosure provides a 3D DRAM 10 that is designed by considering the connections between the memory cells 13 and core circuits, like sense amplifiers 17, word line drivers 22, word line selectors 22, and bit line selectors 170. The disclosure provides a solution for a 1T1C-based 3D DRAM memory cell core, and specifically introduces a way of configuring the 3D DRAM memory cell array and its connection to the sense amplifier(s) 17 and word line driver(s) 22. As a consequence, less area consumption, less parasitic bit line loadings, and less word line drivers 22 can be achieved in the DRAM 10.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A dynamic random access memory, DRAM, (10) comprising:
a block (11) comprising a 3D array of memory cells (13);
wherein the block (11) comprises multiple planes (12) stacked along a first axis, each plane (12) comprising a 2D array of memory cells (13) organized in rows extending along a second axis perpendicular to the first axis and columns extending along a third axis perpendicular to the first and the second axis; and
wherein the block (11) is divided into multiple sub-blocks (14) arranged along the second axis, each sub-block (14) containing one column of memory cells (13) of each plane (12);
the DRAM (10) further comprising:
a plurality of bit lines (15), wherein each bit line (15) extends along the first axis in one of the sub-blocks (14) and is connected to one memory cell (13) in each plane (12);
a plurality of global bit lines (16), wherein one or more of the global bit lines (16) are connected to the bit lines (15) in each sub-block (14); and
a plurality of sense amplifiers (17), wherein each sense amplifier (17) is connected to one of the global bit lines (16).

2. The DRAM (10) of claim 1, wherein each global bit line (16) extends along the third axis, and is associated with one respective sub-block (14), and is connected to all the bit lines (15) in the respective sub-block (14).

3. The DRAM (10) of claim 1, wherein each global bit line (16) extends along the third axis, and each sub-block (14) is associated with a respective group of global bit lines (16), and each global bit line (16) of the respective group is connected to a respective group of bit lines (15) in the sub-block (14).

4. The DRAM (10) of claim 3, wherein each group of bit lines (15) comprises bit lines (15) that are arranged sequentially along the third axis.

5. The DRAM (10) of claim 3, wherein each group of bit lines (15) comprises bit lines (15) that are arranged interleaved along the third axis.

6. The DRAM (10) of one of the claims 2 to 5, further comprising:
a plurality of word lines (21), wherein each word line (21) extends in one of the planes (12) along the second axis, and is connected to one memory cell (13) in each sub-block (14).

7. The DRAM (10) of claim 1, wherein each global bit line (16) extends along the second axis, and is connected to one bit line (15) in each sub-block (14) of the block (11).

8. The DRAM (10) of claim 1, wherein each global bit line (16) extends along the second axis, wherein each global bit line (16) is connected to one bit line (15) in each sub-block (14) of a group of sub-blocks (14) associated with the global bit line (16), and wherein different global bit lines (16) are associated with different groups of sub-blocks (14).

9. The DRAM (10) of claim 8, wherein each group of sub-blocks (14) comprises sub-blocks (14) that are arranged sequentially along the second axis.

10. The DRAM (10) of claim 8, wherein each group of sub-blocks (14) comprises sub-blocks (14) that are arranged interleaved along the second axis.

11. The DRAM (10) of one of the claims 7 to 10, further comprising:
a plurality of word lines (21), wherein each word line (21) extends in one of the planes (12) along the third axis, and is connected to one column of memory cells (13) in that plane (12).

12. The DRAM (10) of claim 6 or 11, further comprising:
a single word line driver (22) shared among all the word lines (21); or
multiple word line drivers (22), wherein each word line driver (22) is shared among all the word lines (21) of the same plane (12).

13. The DRAM (10) of claim 12, further comprising:
one or more word line selectors (23) configured to selectively connect the one or more word line drivers (22) to the word lines (21);
wherein each word line selector (23) comprises a plurality of global word lines (41), and each global word line (41) is connected to a group of word lines (21).

14. The DRAM (10) of claim 6 or 11, further comprising:
a single word line selector (23) shared among all the word lines (21); or
multiple word line selectors (23), wherein each word line selector (23) is shared among all the word lines (21) of the same plane (12);
wherein the one or more word line selectors (23) are configured to selectively connect an output of an address decoder to a plurality of word line drivers (22); and
wherein the plurality of word line drivers (22) are connected to the plurality of word lines (21).

15. The DRAM (10) of claim 14 and claim 6, wherein:
each group of word lines (21) comprises word lines (21) that are arranged sequentially along the third axis if each group of bit lines (15) comprises bit lines (15) that are arranged interleaved along the third axis; or
each group of word lines (21) comprises word lines (21) that are arranged interleaved along the third axis if each group of bit lines (15) comprises bit lines (15) that are arranged sequentially along the third axis.

16. The DRAM (10) of claim 14 and claim 11, wherein:
each group of word lines (21) comprises word lines (21) that are arranged sequentially along the second axis if each group of bit lines (15) comprises bit lines (15) that are arranged interleaved along the second axis; or
each group of word lines (21) comprises word lines (21) that are arranged interleaved along the second axis if each group of bit lines (15) comprises bit lines (15) that are arranged sequentially along the second axis.
